# EUROPEAN PATENT APPLICATION

(11) **EP 4 783 460 A1**
(43) Date of publication of application: **29.07.2026**
(21) Application number: 25829496.6
(22) Date of filing: 12.05.2025
(51) Int. Cl.: H03F 3/20, H04R 3/00

(54) **DRIVING CIRCUIT AND METHOD, AND ELECTRONIC DEVICE**

(30) Priority: 20.06.2024 CN 202410808237
(71) Applicant: HUAWEI TECHNOLOGIES CO., LTD., Shenzhen 518129 (CN)
(72) Inventor: WANG, Shasha, Shenzhen, Guangdong 518129 (CN); ZHAO, Yuming, Shenzhen, Guangdong 518129 (CN); LIU, Guoqing, Shenzhen, Guangdong 518129 (CN); LI, Taian, Shenzhen, Guangdong 518129 (CN); WANG, Tong, Shenzhen, Guangdong 518129 (CN)
(74) Representative: Isarpatent
(86) International application number: PCT/CN2025/094351
(87) International publication number: WO 2025/261014

(57) **Abstract**

This application relates to the field of audio driving technologies, and in particular, to a drive circuit, a driving method, and an electronic device. The method may include: disposing two boost units at an output end of a power amplifier; respectively receiving two channels of signals having opposite phases output by the power amplifier, so that boosted signals output by the two boost units are also signals having opposite phases; and configuring one of the boost units to be connected to a positive electrode of a piezoelectric ceramic component, and the other boost unit to be connected to a negative electrode of the piezoelectric ceramic component, thereby increasing a drive voltage of the piezoelectric ceramic component. The boost units have a simple structure, occupy a relatively small area of a circuit board, and can be effectively used in a miniaturized electronic device.

## Description

This application claims priority to Chinese Patent Application No. 202410808237.6, filed with the China National Intellectual Property Administration on June 20, 2024 and entitled "DRIVE CIRCUIT, DRIVING METHOD, AND ELECTRONIC DEVICE", which is incorporated herein by reference in its entirety.

### TECHNICAL FIELD

This application relates to the field of audio driving technologies, and in particular, to a drive circuit, a driving method, and an electronic device.

### BACKGROUND

As functions of an electronic device increase, a quantity of audio devices in the electronic device also gradually increases. For example, the audio devices may include a conventional speaker, a piezoelectric ceramic, and the like. The speaker is used in scenarios such as phone call sound playing and music playing. Because a signal sent by the piezoelectric ceramic has a relatively high frequency and can be sounded underwater, the piezoelectric ceramic is usually used in scenarios such as alarm audio playing and underwater communication.

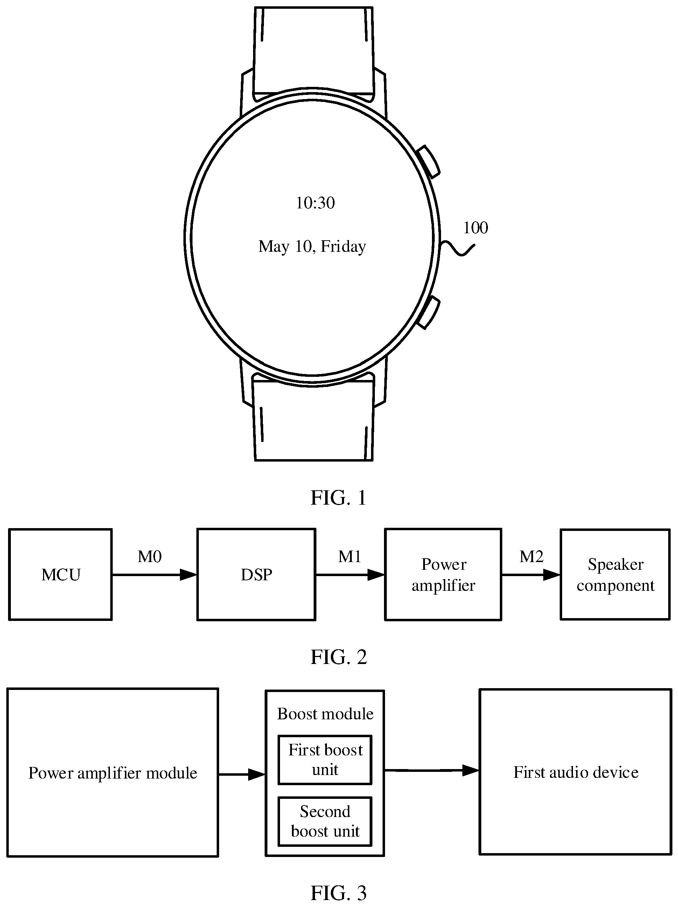

A drive voltage required by the piezoelectric ceramic is far higher than that of the conventional speaker. Therefore, it is usually difficult for a conventional drive voltage of an electronic device to meet driving requirements of the piezoelectric ceramic. For example, a conventional drive voltage of some electronic devices is 10 V, and a drive voltage of the piezoelectric ceramic is 60 V. In some embodiments, an H-bridge and a transformer drive circuit are newly added to an electronic device to implement voltage boost, to implement piezoelectric ceramic driving. However, the H-bridge and the transformer drive circuit are difficult to apply to a miniaturized electronic device (for example, a smart watch shown in FIG. 1) because the H-bridge and the transformer drive circuit have a complex layout and occupy a relatively large area of a circuit board.

### SUMMARY

This application provides a drive circuit, a driving method, and an electronic device, to resolve a problem that an H-bridge and a transformer drive circuit are difficult to apply to a miniaturized electronic device because the H-bridge and the transformer drive circuit have a complex layout and occupy a relatively large area of a circuit board.

According to a first aspect, this application provides a drive circuit, including a power amplifier module, a boost module, and a first audio device, where the boost module includes a first boost unit and a second boost unit;
the power amplifier module is configured to output a first audio signal to the first boost unit, and output a second audio signal to the second boost unit, where a phase of the first audio signal is opposite to a phase of the second audio signal; and
the first boost unit is configured to perform voltage amplification on the first audio signal to obtain a third audio signal, and send the third audio signal to a positive electrode of the first audio device, and the second boost unit is configured to perform voltage amplification on the second audio signal to obtain a fourth audio signal, and send the fourth audio signal to a negative electrode of the first audio device.

Based on the solution of this application, a double drive voltage can be obtained, and a drive voltage of the piezoelectric ceramic component can be met. For example, when one boost unit (for example, the first boost unit) outputs a signal of +30 V, and the other boost unit (for example, the second boost unit) outputs a signal of -30 V, a voltage on the piezoelectric ceramic component is a difference between +30 V and -30 V, that is, 60 V. It may be understood that the boost units have a simple structure, occupy a relatively small area of a circuit board, and can be effectively used in a miniaturized electronic device.

In a possible implementation of the first aspect, the first audio device is a piezoelectric ceramic component.

In a possible implementation of the first aspect, the power amplifier module includes a first power amplifier, a first filter, and a second filter, and the power amplifier is separately connected to the first filter and the second filter; the first power amplifier is configured to output a fifth audio signal to the first filter, and output a sixth audio signal to the second filter, where a phase of the fifth audio signal is opposite to a phase of the sixth audio signal; the first filter is configured to perform filtering on the fifth audio signal to obtain the first audio signal; and the second filter is configured to perform filtering on the sixth audio signal to obtain the second audio signal.

It may be understood that, in this embodiment of this application, if the phases of the fifth audio signal and the sixth audio signal are opposite, the phases of the first audio signal and the second audio signal are also opposite. The first filter may be a first band-pass filter, and the second filter may be a second band-pass filter.

In a possible implementation of the first aspect, the first boost unit includes a first operational amplifier, and the second boost unit includes a second operational amplifier; a first end of the first operational amplifier is connected to the first filter, and a second end of the first operational amplifier is connected to a positive electrode of the piezoelectric ceramic component; and a first end of the second operational amplifier is connected to the second filter, and a second end of the second operational amplifier is connected to a negative electrode of the piezoelectric ceramic component.

In a possible implementation of the first aspect, the first boost unit further includes a first matching unit, and the second boost unit further includes a second matching unit; that the second end of the first operational amplifier is connected to the positive electrode of the piezoelectric ceramic component includes: the second end of the first operational amplifier is connected to a first end of the first matching unit, and a second end of the first matching unit is connected to the positive electrode of the piezoelectric ceramic component; and that the second end of the second operational amplifier is connected to the negative electrode of the piezoelectric ceramic component includes: the second end of the second operational amplifier is connected to a first end of the second matching unit, and a second end of the second matching unit is connected to the negative electrode of the piezoelectric ceramic component.

In a possible implementation of the first aspect, the boost module further includes a voltage amplification unit, a first end of the voltage amplification unit is connected to the first operational amplifier, and a second end of the voltage amplification unit is connected to the second operational amplifier; the voltage amplification unit is configured to amplify a first voltage of a power supply to obtain a second voltage; the first operational amplifier is configured to send the third audio signal to the positive electrode of the piezoelectric ceramic component by using the second voltage; and the second operational amplifier is configured to send the fourth audio signal to the negative electrode of the piezoelectric ceramic component by using the second voltage.

It may be understood that, in this embodiment of this application, the first operational amplifier is configured to send, to the positive electrode of the piezoelectric ceramic component by using the second voltage, a signal output by the first filter, that is, send the third audio signal having the second voltage to the positive electrode of the piezoelectric ceramic component. The second operational amplifier is configured to send, to the negative electrode of the piezoelectric ceramic component by using the second voltage, a signal output by the second filter, that is, send the fourth audio signal having the second voltage to the negative electrode of the piezoelectric ceramic component. It may be understood that, because the signal output by the first filter and the signal output by the second filter are signals having opposite phases, signals output by the first operational amplifier and the second operational amplifier are boosted signals with opposite polarities.

In a possible implementation of the first aspect, the drive circuit further includes a switch module and a second audio device, where the switch module is configured to control electrical connection and disconnection between the first power amplifier and the second audio device, and control electrical connection and disconnection between the first power amplifier and the piezoelectric ceramic component.

In a possible implementation of the first aspect, the switch module includes a first switch unit and a second switch unit, where a first end of the first switch unit is connected to the first power amplifier, a second end of the first switch unit is connected to the first filter, and a third end of the first switch unit is connected to a positive electrode of the second audio device; and a first end of the second switch unit is connected to the first power amplifier, a second end of the second switch unit is connected to the second filter, and the second end of the second switch unit is connected to a negative electrode of the second audio device.

In this embodiment of this application, the switch module may play audio by using different audio devices in different scenarios. For example, when music needs to be played, the first power amplifier is controlled to be electrically connected to the speaker component, and the first power amplifier is controlled to be disconnected from the piezoelectric ceramic component; and when an alarm tone needs to be played, the first power amplifier is controlled to be electrically connected to the piezoelectric ceramic component, and the first power amplifier is controlled to be disconnected from the speaker component.

In a possible implementation of the first aspect, the drive circuit further includes a second audio device, where the power amplifier module further includes a second power amplifier, and the second power amplifier is connected to the second audio device; and the second power amplifier is configured to output a seventh audio signal to the second audio device.

In some embodiments, a plurality of power amplifiers may be disposed to drive different audio devices.

In a possible implementation of the first aspect, the drive circuit further includes a second audio device, where the power amplifier module includes a multichannel power amplifier; a first channel of the multichannel power amplifier is connected to the first audio device; and a second channel of the multichannel power amplifier is connected to the second audio device.

In a possible implementation of the first aspect, the second audio device is a speaker component.

In a possible implementation of the first aspect, the drive circuit further includes a controller and a digital signal processor, where the digital signal processor is configured to output an eighth audio signal to the digital signal processor; and the digital signal processor is configured to perform digital processing on the eighth audio signal to obtain a ninth audio signal, and output the ninth audio signal to the power amplifier module.

According to a second aspect, this application provides a driving method, applied to an electronic device. The electronic device includes the drive circuit mentioned in this application, and the method includes: determining that the first audio device needs to be driven to play target audio; controlling the power amplifier module to output a first audio signal corresponding to the target audio to the first boost unit and output a second audio signal corresponding to the target audio to the second boost unit, where a phase of the first audio signal is opposite to a phase of the second audio signal; and controlling the first boost unit to perform voltage amplification on the first audio signal to obtain a third audio signal, and send the third audio signal to the positive electrode of the first audio device, and controlling the second boost unit to perform voltage amplification on the second audio signal to obtain a fourth audio signal, and send the fourth audio signal to the negative electrode of the first audio device.

In a possible implementation of the second aspect, determining that the first audio device needs to be driven to play the target audio includes:
detecting an incoming call; obtaining an ambient noise value of the electronic device; and in response to the ambient noise value being greater than a first threshold and a noise duration being greater than a first duration, determining that the first audio device and the second audio device need to be driven to play incoming call audio.

It may be understood that the speaker component and the piezoelectric ceramic component work simultaneously. As an extension of a high frequency, the piezoelectric ceramic component may improve downlink loudness of a call, that is, improve call intelligibility, and further improve user experience.

In a possible implementation of the second aspect, the method further includes: in response to the ambient noise value being less than or equal to the first threshold, determining that the second audio device needs to be driven to play the incoming call audio; and in response to the ambient noise value being greater than the first threshold and the noise duration being less than or equal to the first duration, determining that the second audio device needs to be driven to play the incoming call audio.

According to a third aspect, this application provides an electronic device, including the drive circuit mentioned in this application.

According to a fourth aspect, this application provides an electronic device, including a memory, configured to store instructions to be executed by one or more processors of the electronic device, and a processor that is one of the processors of the electronic device, configured to perform the driving method mentioned in this application.

### BRIEF DESCRIPTION OF DRAWINGS

FIG. 1 is a diagram of a smart watch according to some embodiments of this application;
FIG. 2 is a diagram of a structure of a speaker drive circuit according to some embodiments of this application;
FIG. 3 is a diagram of a structure of a first type of drive circuit according to some embodiments of this application;
FIG. 4 is a diagram of a structure of a second type of drive circuit according to some embodiments of this application;
FIG. 5 is a diagram of a structure of a third type of drive circuit according to some embodiments of this application;
FIG. 6 is a diagram of a structure of a fourth type of drive circuit according to some embodiments of this application;
FIG. 7 is a diagram of a structure of a fifth type of drive circuit according to some embodiments of this application;
FIG. 8 shows a measured effect of a drive circuit on a product according to some embodiments of this application;
FIG. 9 is a flowchart of a driving method according to some embodiments of this application; and
FIG. 10 is a diagram of an electronic device according to some embodiments of this application.

### DESCRIPTION OF EMBODIMENTS

Illustrative embodiments of this application include but are not limited to a drive circuit, a driving method, and an electronic device.

It should be noted that a specific form of the electronic device is not limited in this application. The electronic device may be an electronic device such as a mobile phone, a notebook computer, a tablet computer, a large screen device, a wearable device (for example, a smart watch, smart glasses, or a helmet), a desktop computer, an augmented reality (augmented reality, AR)/a virtual reality (virtual reality, VR) device, or a personal digital assistant (personal digital assistant, PDA). This is not limited herein.

To better understand solutions of this application, a driving principle of a speaker is first described with reference to a structure of a speaker drive circuit shown in FIG. 2.

As shown in FIG. 2, the structure of the speaker drive circuit may include a microcontroller unit (microcontroller unit, MCU), a digital signal processor (digital signal processor, DSP), a power amplifier (power amplifier for short), and a speaker component. When the speaker component needs to play audio, the MCU may send an audio signal M0 to the DSP, and the DSP performs digital processing on the audio signal, that is, converts the audio signal M0 (a signal represented by a waveform) into a digital signal M1 formed by digits 0 and 1. Then, a processed digital signal M1 is sent to the power amplifier. The power amplifier performs power amplification on the signal M1 to obtain a signal M2, and sends the signal M2 to the speaker component. The speaker component plays corresponding audio based on the signal M2. It may be understood that, currently, a power amplifier generally uses a differential signal technology to split an input signal into two channels of signals having opposite phases, and then performs power amplification on the two signals having opposite phases and outputs the signals, to improve fidelity of audio signals output by the power amplifier.

It may be understood that, as described above, for a piezoelectric ceramic component (or referred to as piezoelectric ceramic), a conventional drive voltage of an electronic device cannot reach a drive voltage of the piezoelectric ceramic component. For example, a maximum drive voltage that can be provided by the smart watch based on a current boost unit (for example, a differential amplifier) is 30 V, but the drive voltage of the piezoelectric ceramic component needs to be nearly 60 V. To resolve this problem, in some embodiments, an H-bridge circuit and a transformer drive circuit are newly added to drive the piezoelectric ceramic component. However, the H-bridge and the transformer drive circuit are difficult to apply to a miniaturized electronic device (for example, a smart watch) because the H-bridge and the transformer drive circuit have a complex layout and occupy a relatively large area of a circuit board.

To resolve the foregoing problem, this application provides a drive circuit. Based on a characteristic that signals output by a power amplifier in the speaker component drive circuit are two channels of signals having opposite phases, two boost units are disposed at an output end of the power amplifier, and two channels of signals having opposite phases output by the power amplifier are respectively received, so that boosted signals output by the two boost units are also signals having opposite phases, where the signals having the opposite phases may be considered as the signals carrying opposite voltage polarities. In addition, based on that the voltage on the electronic device is an electric potential difference between a positive electrode and a negative electrode (that is, a difference between a voltage at the positive electrode and a voltage at the negative electrode), one boost unit is configured to be connected to a positive electrode of the piezoelectric ceramic component, and the other boost unit is configured to be connected to a negative electrode of the piezoelectric ceramic component. In this way, the drive voltage on the piezoelectric ceramic component may be twice an output voltage of a boost unit.

For example, as described above, a maximum drive voltage that can be provided by the current boost unit is 30 V. Based on the solution of this application, when one boost unit outputs a signal of +30 V, and the other boost unit outputs a signal of -30 V, a voltage on the piezoelectric ceramic component is a difference between +30 V and -30 V, that is, 60 V. In this way, the drive voltage of the piezoelectric ceramic component can be met. It may be understood that the boost units have a simple structure, occupy a relatively small area of a circuit board, and can be effectively used in a miniaturized electronic device.

For example, FIG. 3 is a diagram of a drive circuit. As shown in FIG. 3, the drive circuit includes a power amplifier module, a boost module, and a first audio device, where the boost module includes a first boost unit and a second boost unit, and the first audio device is a piezoelectric ceramic component.

The power amplifier module is configured to output a first audio signal to the first boost unit, and output a second audio signal to the second boost unit, where a phase of the first audio signal is opposite to a phase of the second audio signal; and
the first boost unit is configured to perform voltage amplification on the first audio signal to obtain a third audio signal, and send the third audio signal to a positive electrode of the first audio device, and the second boost unit is configured to perform voltage amplification on the second audio signal to obtain a fourth audio signal, and send the fourth audio signal to a negative electrode of the first audio device.

**The following describes in detail a structure of a drive circuit provided in an embodiment of this application.**

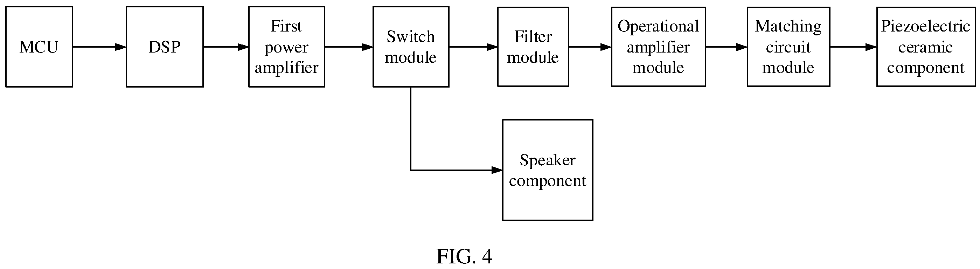

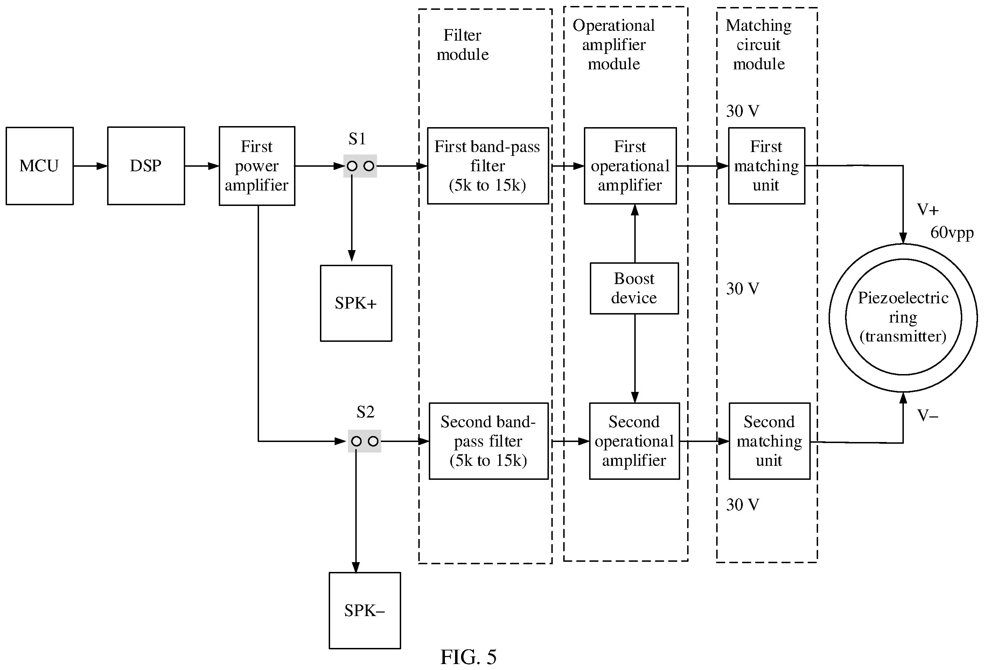

FIG. 4 and FIG. 5 are diagrams of a drive circuit. As shown in FIG. 4, the drive circuit includes a processor, a DSP, a first power amplifier, a switch module, a filter module, an operational amplifier module (that is, a boost module mentioned in this application), a matching circuit module, a piezoelectric ceramic component, and a second audio device. The power amplifier module and the filter module may be constituent parts of the power amplifier module, the second audio device may be a speaker component, and the processor may be an MCU.

As shown in FIG. 5, the first power amplifier may be a small power amplifier, so that an occupied area of the drive circuit can be further reduced.

The MCU may be configured to send, to the DSP for processing, a signal (for example, a signal MO, that is, the eighth audio signal mentioned in this application) corresponding to audio that needs to be played. The DSP is configured to send a processed signal (for example, a signal M1, that is, the ninth audio signal mentioned in this application) to the first power amplifier. The first power amplifier is configured to perform power amplification on the signal M1 to generate a differential signal M2, where the differential signal M2 may include a first channel of signal (that is, the fifth audio signal mentioned in this application) and a second channel of signal (that is, the sixth audio signal mentioned in this application), the first channel of signal and the second channel of signal are signals having opposite phases.

The switch module may include a first switch unit and a second switch unit. The first switch unit may include a first switch S1, and the second switch unit may include a second switch S2. The filter module includes a first filter and a second filter. The first filter may be a first band-pass filter, and the second filter may be a second band-pass filter. The first switch S1 is configured to control disconnection and electrical connection between the first power amplifier and the first band-pass filter and between the first power amplifier and a positive electrode (SPK+) of the speaker component, and the second switch S2 is configured to control disconnection and electrical connection between the first power amplifier and the second band-pass filter and between the first power amplifier and a negative electrode (SPK-) of the speaker component. For example, when the piezoelectric ceramic component needs to be driven but the speaker component does not need to be driven, the first switch and the second switch may control the first power amplifier to be separately electrically connected to the first band-pass filter and the second band-pass filter. For example, when the speaker component needs to be driven but the piezoelectric ceramic component does not need to be driven, the first switch and the second switch may control the first power amplifier to be separately disconnected from the first band-pass filter and the second band-pass filter, and control the first power amplifier to be electrically connected to the positive electrode (SPK+) of the speaker component and the negative electrode (SPK-) of the speaker component. The switch module may play audio by using different audio devices in different scenarios. For example, when music needs to be played, the first power amplifier is controlled to be electrically connected to the speaker component, and the first power amplifier is controlled to be disconnected from the piezoelectric ceramic component; and when an alarm tone needs to be played, the first power amplifier is controlled to be electrically connected to the piezoelectric ceramic component, and the first power amplifier is controlled to be disconnected from the speaker component.

The first band-pass filter is configured to filter the first channel of signal sent by the first power amplifier, and the second band-pass filter is configured to filter the second channel of signal sent by the first power amplifier, to obtain two channels of signals (that is, the first audio signal and the second audio signal mentioned in this application) that meet a bandwidth range of a drive signal of the piezoelectric ceramic component. The two channels of signals are signals having opposite phases. Filter ranges of both the first band-pass filter and the second band-pass filter may be 5 kHz to 15 kHz. The value is merely an example for description, and may be set according to an actual requirement. This is not limited herein.

It may be understood that a bandwidth of a signal output by the power amplifier is generally a relatively wide bandwidth range (for example, 20 Hz to 3 MHz). Therefore, a filter needs to be disposed at the output end of the power amplifier to screen the signal output by the power amplifier, to obtain a signal (for example, 5 kHz to 15 kHz) that meets the bandwidth range of the drive signal of the piezoelectric ceramic component. It may be understood that the first band-pass filter and the second band-pass filter are configured to filter the signal output by the first power amplifier, so that an invalid signal can be effectively filtered out, and a signal-to-noise ratio of the signal is improved, to obtain a better effect.

The operational amplifier module includes a first boost unit, a second boost unit, and a voltage amplification unit. A first end of the voltage amplification unit is connected to the first operational amplifier, and a second end of the voltage amplification unit is connected to the second operational amplifier; a first end of the first operational amplifier is connected to the first filter, and a second end of the first operational amplifier is connected to the positive electrode of the piezoelectric ceramic component; and a first end of the second operational amplifier is connected to the second filter, and a second end of the second operational amplifier is connected to the negative electrode of the piezoelectric ceramic component.

The first boost unit may be the first operational amplifier, the second boost unit may be the second operational amplifier, and the voltage amplification unit may be any device that can implement voltage amplification, for example, a boost chip. The boost chip is configured to boost a first voltage of a power supply of the electronic device, that is, perform voltage amplification to obtain a second voltage, and supply power to the first operational amplifier and the second operational amplifier by using the boosted second voltage. The first operational amplifier is configured to send, to the positive electrode of the piezoelectric ceramic component by using the second voltage, a signal output by the first band-pass filter, that is, send the third audio signal having the second voltage to the positive electrode of the piezoelectric ceramic component. The second operational amplifier is configured to send, to the negative electrode of the piezoelectric ceramic component by using the second voltage, a signal output by the second band-pass filter, that is, send the fourth audio signal having the second voltage to the negative electrode of the piezoelectric ceramic component. It may be understood that, because the signal output by the first band-pass filter and the signal output by the second band-pass filter are signals having opposite phases, signals output by the first operational amplifier and the second operational amplifier are boosted signals with opposite polarities.

For example, a voltage of the power supply is 3 V, and the boost chip may boost the voltage of the power supply to 30 V, to supply power to the first operational amplifier and the second operational amplifier by using a supply voltage of 30 V. If a phase of the signal output by the first band-pass filter is positive, and a phase of the signal output by the second band-pass filter is negative, the first operational amplifier may output a signal of +30 V, and the second operational amplifier may output a signal of -30 V.

The piezoelectric ceramic component may be a piezoelectric ring. It may be understood that a drive voltage on the piezoelectric ring is a difference between a voltage output by the first operational amplifier and a voltage output by the second operational amplifier. For example, when the first operational amplifier may output a signal of +30 V, and the second operational amplifier may output a signal of -30 V, the voltage on the piezoelectric ring is 60 V. In this way, after the voltage of the power supply is boosted by using the boost chip, the drive circuit provided in this application may continue to implement further double increase of a voltage by using two operational amplifiers, thereby enhancing a driving capability of the piezoelectric ceramic component.

The matching circuit module may include a first matching unit and a second matching unit. The second end of the first operational amplifier is connected to a first end of the first matching unit, and a second end of the first matching unit is connected to the positive electrode of the piezoelectric ceramic component; and the second end of the second operational amplifier is connected to a first end of the second matching unit, and a second end of the second matching unit is connected to the negative electrode of the piezoelectric ceramic component. The first matching unit is configured to perform impedance matching on the first operational amplifier, and the second matching unit is configured to perform impedance matching on the second operational amplifier. Impedance matching may implement matching between impedance of an input circuit and an output circuit of an operational amplifier and internal impedance of the operational amplifier, to ensure maximum transmission and minimum distortion of an output signal of the operational amplifier.

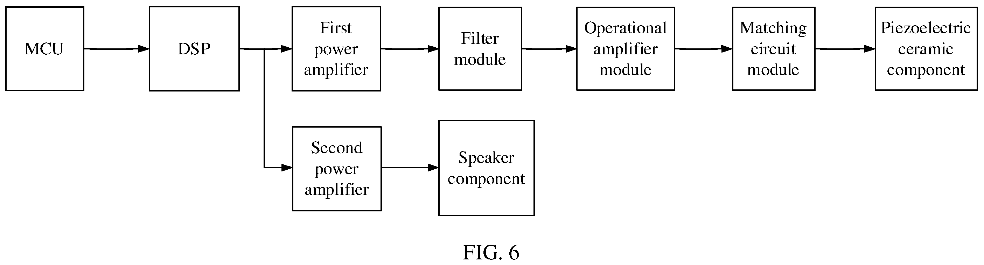

In some embodiments, a plurality of power amplifiers may alternatively be disposed to drive different audio devices. FIG. 6 is a diagram of a drive circuit. As shown in FIG. 6, the drive circuit includes an MCU, a DSP, a first power amplifier, a second power amplifier, a filter module, an operational amplifier module (that is, the boost module mentioned in this application), a matching circuit module, a piezoelectric ceramic component, and a speaker component. The first power amplifier is electrically connected to the piezoelectric ceramic component, and the second power amplifier is electrically connected to the speaker component.

The first power amplifier is configured to output a first channel of signal to the first band-pass filter, and output a second channel of signal to the second band-pass filter.

The second power amplifier is configured to output a third channel of signal to the positive electrode of the speaker component, and output a fourth channel of signal to the positive electrode of the speaker component. The third channel of signal and the fourth channel of signal may be signals in seventh signals mentioned in this application.

For descriptions of other modules in FIG. 6, refer to the foregoing descriptions in FIG. 4 and FIG. 5. Details are not described herein again.

In some embodiments, a switch module may alternatively be disposed between the first power amplifier and the first band-pass filter and between the first power amplifier and the second band-pass filter, and is configured to control disconnection and electrical connection between the first power amplifier and the first band-pass filter and disconnection and electrical connection between the first power amplifier and the second band-pass filter.

In some embodiments, a switch module may alternatively be disposed between the first power amplifier and the speaker component, and is configured to control disconnection and electrical connection between the first power amplifier and the speaker component.

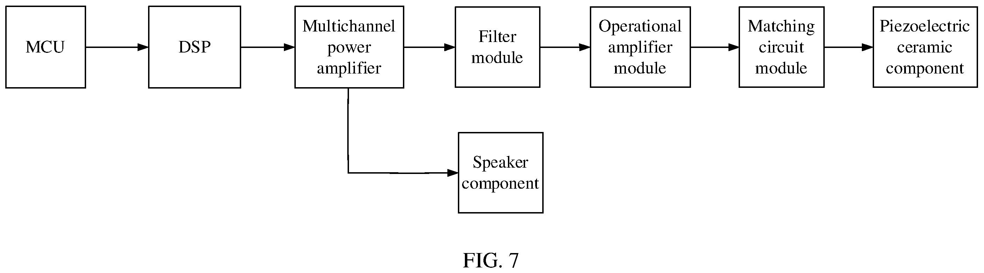

In some embodiments, a multichannel power amplifier may be used to replace the plurality of power amplifiers. FIG. 7 is a diagram of a drive circuit. As shown in FIG. 7, the drive circuit includes an MCU, a DSP, a multichannel power amplifier, a filter module, an operational amplifier module (that is, the boost module mentioned in this application), a matching circuit module, a piezoelectric ceramic component, and a speaker component. A first channel of the multichannel power amplifier is separately connected to a first filter and a second filter, and a second channel of the multichannel power amplifier is connected to a second audio device.

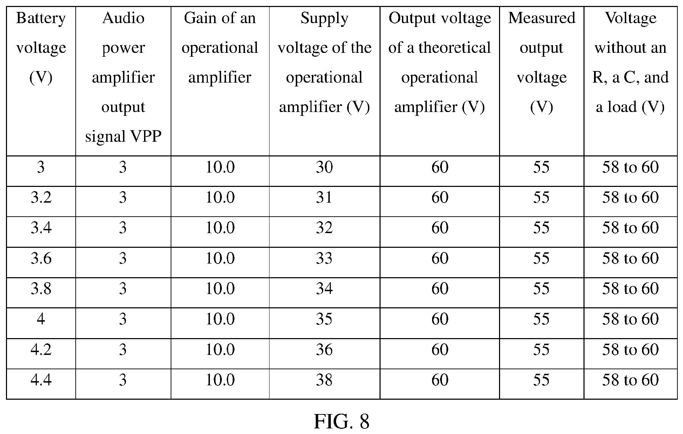

The following describes an actual measurement effect of the drive circuit in this application on a product with reference to FIG. 8. The product may be a smart watch. As shown in FIG. 8, when a battery voltage is 3 V, output signals of an audio power amplifier (that is, the first power amplifier mentioned in this application) are respectively of 3 V, 3.2 V, 3.4 V, 3.6 V, 3.8 V, 4 V, 4.2 V, and 4.4 V, and a gain of the operational amplifier is 10, supply voltages of the operational amplifier are all 30 V, signal voltages output by a theoretical operational amplifier are respectively 30 V, 31 V, 32 V, 33 V, 34 V, 35 V, 36 V, 37 V, and 38 V, measured output signal voltages are all 55 V, and voltage ranges without an R, a C and a load all range from 58 V to 60 V.

It can be learned from FIG. 8 that the drive circuit provided in this embodiment of this application can implement double voltage boosting, enhance a drive capability, and meet a drive voltage of the piezoelectric ceramic component.

In conclusion, the drive circuit provided in this embodiment of this application can drive a high voltage of the piezoelectric ceramic component in a differential manner based on miniaturization. In addition, a drive path of the piezoelectric ceramic component in the drive circuit provided in this embodiment of this application may share a part of a circuit with the speaker component, and no additional design is required, so that a layout area can be greatly reduced.

Moreover, the drive circuit provided in this embodiment of this application may drive the speaker component to work, or drive the piezoelectric ceramic component to work, or may drive both the speaker component and the piezoelectric ceramic component to implement bandwidth extension and improve an audio playing effect. In some embodiments, the speaker component and the piezoelectric ceramic component may also be used separately. The piezoelectric ceramic component is used as a communications device, for example, for alarming and underwater communication. The speaker component is used as a playing device, for example, for playing music.

In addition, in this embodiment of this application, a signal obtained after filtering by the first band-pass filter and the first band-pass filter is a sine wave signal. In some driving solutions in comparative embodiments, the MCU outputs a pulse width modulation waveform to drive the piezoelectric ceramic component in a single-ended manner. Compared with the comparative embodiments, a driving capability of a sine wave provided in this embodiment of this application is twice that of the pulse width modulation waveform.

In addition, in this embodiment of this application, all data corresponding to the target audio that needs to be played by the piezoelectric ceramic component may be stored in a file system for ease of reading.

The following describes, with reference to the foregoing circuit, an audio driving method provided in this application. The audio driving method mentioned in an embodiment of this application may be applied to an electronic device. The electronic device may include the foregoing drive circuit. In some embodiments, when determining that a first audio device needs to be driven to play target audio, the electronic device may control the power amplifier module to output a first audio signal corresponding to the target audio to the first boost unit and output a second audio signal corresponding to the target audio to the second boost unit, where a phase of the first audio signal is opposite to a phase of the second audio signal; and controlling the first boost unit to perform voltage amplification on the first audio signal to obtain a third audio signal, and send the third audio signal to the positive electrode of the first audio device, and controlling the second boost unit to perform voltage amplification on the second audio signal to obtain a fourth audio signal, and send the fourth audio signal to the negative electrode of the first audio device.

In some embodiments, the driving method mentioned in this application may be performed by a processor of an electronic device.

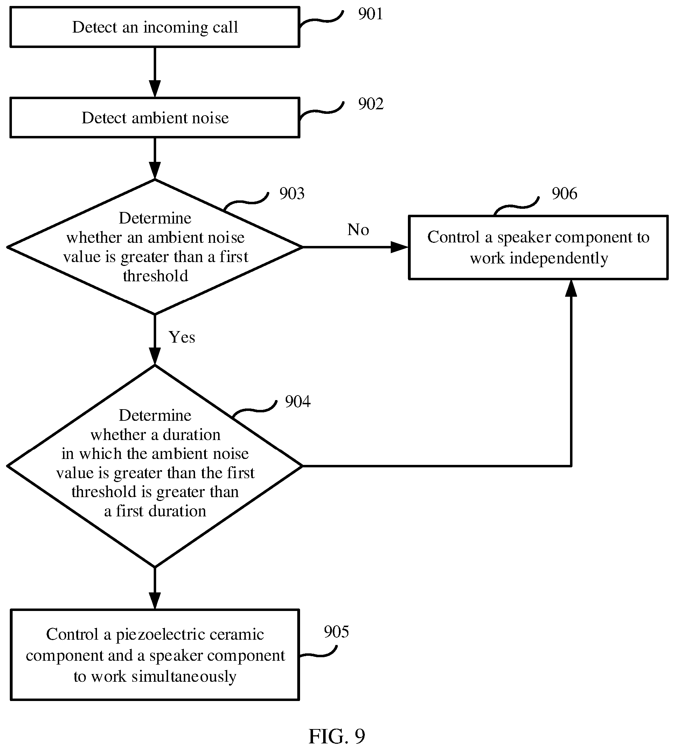

In some embodiments, audio may be played based on different audio devices in different scenarios, to meet requirements of the different scenarios. FIG. 9 is a schematic flowchart of implementation of a driving method. The method shown in FIG. 9 may be applied to an electronic device, and the electronic device may include the drive circuit mentioned above. As shown in FIG. 9, an implementation process of the driving method may include the following steps.

901: Detect an incoming call.

It may be understood that the incoming call may include an incoming telephone call, an incoming voice call, an incoming video call, and the like.

902: Detect ambient noise.

In some embodiments, a microphone may be used to collect a surrounding ambient sound, and then the processor detects the surrounding ambient sound to obtain an ambient noise value of the electronic device. In some embodiments, the ambient noise value of the electronic device may alternatively be obtained by using a microphone. In some embodiments, the ambient noise value may be replaced with any data representing the ambient noise. This is not limited in this application.

903: Determine whether the ambient noise value is greater than a first threshold.

If the ambient noise value is greater than the first threshold, the process proceeds to 904 to determine whether a duration in which the ambient noise value is greater than the first threshold is greater than a first duration. If the ambient noise value is not greater than the first threshold, the process proceeds to 906 to control the speaker component to work independently.

For example, the first threshold may be, for example, 70 decibels, and the first threshold may be determined according to an actual requirement. This is not limited in this application.

904: Determine whether the duration in which the ambient noise value is greater than the first threshold is greater than the first duration.

If the duration in which the ambient noise value is greater than the first threshold is greater than the first duration, the process proceeds to 905 to control the piezoelectric ceramic component and the speaker component to work simultaneously. If the ambient noise value is not greater than the first threshold, the process proceeds to 906 to control the speaker component to work independently.

For example, the first duration may be, for example, 2s, and the first duration may be determined according to an actual requirement. This is not limited in this application.

905: Control the piezoelectric ceramic component and the speaker component to work simultaneously.

It may be understood that the speaker component and the piezoelectric ceramic component work simultaneously. As an extension of a high frequency, the piezoelectric ceramic component may improve downlink loudness of a call, that is, improve call intelligibility, and further improve user experience.

In addition, compared with a solution in which a PWM wave and a transformer are used to drive a piezoelectric ceramic component in a conventional solution, in the solution of this application, based on the drive circuit provided in this application, synchronization between a signal of a speaker component and a piezoelectric ceramic component is very good, a delay is low, and user experience is further improved.

906: Control the speaker component to work independently.

It may be understood that, in this application, when it is determined that the piezoelectric ceramic component needs to play the incoming call audio, the piezoelectric ceramic component may be controlled to work independently. When it is determined that the speaker component needs to play the incoming call audio, the speaker component is controlled to work independently. When it is determined that the speaker component and the piezoelectric ceramic component need to play the incoming call audio together, the speaker component and the piezoelectric ceramic component are controlled to work. The incoming call audio may include an incoming call sound, or may include a voice of a peer party in a call process after a call is received.

When the drive circuit is the drive circuit shown in FIG. 3 to FIG. 5, a manner of controlling the piezoelectric ceramic component to work may be: controlling the power amplifier module to output the first audio signal corresponding to the target audio to the first boost unit and output the second audio signal corresponding to the target audio to the second boost unit; controlling the first boost unit to perform voltage amplification on the first audio signal to obtain the third audio signal, and send the third audio signal to the positive electrode of the piezoelectric ceramic component, and controlling the second boost unit to perform voltage amplification on the second audio signal to obtain a fourth audio signal, and send the fourth audio signal to the negative electrode of the piezoelectric ceramic component.

In this application, a manner of controlling the speaker component to work may be controlling the first power amplifier to be connected to the speaker component, so that the first power amplifier sends an audio signal to the speaker component, and the speaker component makes a sound.

In this application, a manner of controlling the speaker component and the piezoelectric ceramic component to work together may be controlling both the first power amplifier and the piezoelectric ceramic component, and the first power amplifier and the speaker component to be in an electrically connected state, that is, a working state, so that the piezoelectric ceramic component and the speaker component make a sound together.

For details about specific circuit signal transmission, refer to circuit descriptions related to FIG. 3 to FIG. 5. Details are not described herein again.

When the drive circuit is the drive circuit shown in FIG. 6, a manner of controlling the piezoelectric ceramic component to work may be controlling the first power amplifier and the piezoelectric ceramic component to be in an electrically connected state, that is, a working state, and a manner of controlling the speaker component to work may be controlling the second power amplifier and the speaker component to be in an electrically connected state, that is, a working state. The manner of controlling the speaker component and the piezoelectric ceramic component to work together may be controlling both the first power amplifier and the piezoelectric ceramic component, and the second power amplifier and the speaker component to be in an electrically connected state, that is, a working state.

When the drive circuit is the drive circuit shown in FIG. 7, a manner of controlling the piezoelectric ceramic component to work may be controlling the first channel of the multichannel power amplifier and the piezoelectric ceramic component to be in an electrically connected state, that is, a working state, and a manner of controlling the speaker component to work may be controlling the second channel of the multichannel power amplifier and the speaker component to be in an electrically connected state, that is, a working state. The manner of controlling the speaker component and the piezoelectric ceramic component to work together may be controlling both the first channel and the piezoelectric ceramic component, and the second channel and the speaker component to be in an electrically connected state, that is, a working state.

Based on the foregoing solution, when ambient noise of a user is relatively small, the speaker component is used to make a sound. When the ambient noise is relatively large, the speaker component and the piezoelectric ceramic component make a sound together, and a delay is low and intelligibility is high, so that the user can have better auditory experience when the ambient noise is high. In addition, an audio device that needs to be used is determined by using a noise threshold and a noise duration threshold, and when the noise is relatively small, only the speaker component is controlled to work, which can reduce power consumption of the electronic device in a playing process.

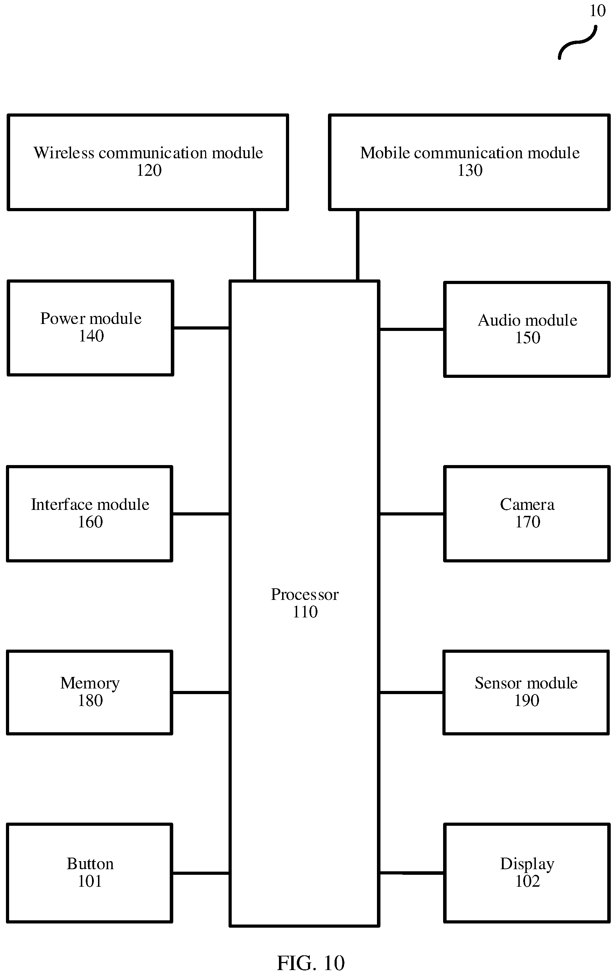

FIG. 10 is a diagram of an electronic device according to an embodiment of this application. An electronic device 10 may include the drive circuit mentioned in this application, a processor 110, a power module 140, a memory 180, a mobile communication module 130, a wireless communication module 120, a sensor module 190, an audio module 150, a camera 170, an interface module 160, a button 101, a display 102, and the like.

It may be understood that the structure shown in this embodiment of the present invention constitutes no specific limitation on the electronic device 10. In some other embodiments of this application, the electronic device 10 may include more or fewer components than those shown in the figure, or some components may be combined, or some components may be split, or there may be a different component layout. The components shown in the figure may be implemented by hardware, software, or a combination of software and hardware.

The processor 110 may include one or more processing units, for example, may include a processing module or a processing circuit such as a central processing unit, an image processor, a digital signal processor, a microprocessor, an artificial intelligence processor, or a programmable logic device. Different processing units may be independent devices, or may be integrated into one or more processors. A storage unit may be disposed in the processor 110, to store instructions and data. In some embodiments, the storage unit in the processor 110 is the cache 180, and the processor may be configured to perform the driving method in embodiments of this application.

The power module 140 may include a power supply, a power management component, and the like. The power supply may be a battery. The power management component is configured to manage charging of the power supply and power supplying of the power supply to the other modules. In some embodiments, the power management component includes a charging management module and a power management module. The charging management module is configured to receive a charging input from a charger. The power management module is configured to connect to the power supply, the charging management module, and the processor 110. The power management module receives an input from the power supply and/or the charging management module, and supplies power to the processor 110, the display 102, the camera 170, the wireless communication module 120, and the like.

The mobile communication module 130 may include, but is not limited to, an antenna, a power amplifier, a filter, a low noise amplifier, and the like. The mobile communication module 130 may provide a wireless communication solution that is applied to the electronic device 10 and that includes 2G, 3G, 4G, 5G, and the like. The mobile communication module 130 may receive an electromagnetic wave through the antenna, perform processing such as filtering or amplification on the received electromagnetic wave, and transmit the electromagnetic wave to a modem processor for demodulation. The mobile communication module 130 may further amplify a signal modulated by the modem processor, and convert the signal into an electromagnetic wave for radiation through the antenna. In some embodiments, at least some functional modules of the mobile communication module 130 may be disposed in the processor 110. In some embodiments, at least some functional modules of the mobile communication module 130 and at least some modules of the processor 110 may be disposed in a same component.

The wireless communication module 120 may include an antenna, and receive and send an electromagnetic wave through the antenna. The wireless communication module 120 may provide a solution that includes wireless communication such as a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), near field communication (near field communication, NFC), an infrared (infrared, IR) technology and that is applied to the electronic device 10. The electronic device 10 can communicate with a network and another device by using wireless communication technologies.

In some embodiments, the mobile communication module 130 and the wireless communication module 120 that are of the electronic device 10 may alternatively be located in a same module.

The display 102 is configured to display a human-computer interaction interface, an image, a video, and the like.

The sensor module 190 may include an optical proximity sensor, a pressure sensor, a gyroscope sensor, a barometric pressure sensor, a magnetic sensor, an acceleration sensor, a distance sensor, a fingerprint sensor, a temperature sensor, a touch sensor, an ambient light sensor, a bone conduction sensor, and the like. The sensor module is configured to detect a heart rate, blood oxygen, an altitude, a step count, a wearing status, and the like of a user.

The audio module 150 is configured to convert digital audio information into an analog audio signal for output, or convert analog audio input into a digital audio signal. The audio module 150 may be further configured to encode and decode an audio signal. In some embodiments, the audio module 150 may be disposed in the processor 110, or some functional modules of the audio module 150 are disposed in the processor 110. In some embodiments, the audio module 150 may include a speaker component, a piezoelectric ceramic component, a receiver, a microphone, and a headset jack. In some embodiments, the speaker component and the piezoelectric ceramic component may alternatively be constituent parts of the drive circuit in this application.

The interface module 160 includes an interface for external memory, a universal serial bus (universal serial bus, USB) interface, a subscriber identification module (subscriber identification module, SIM) card interface, and the like. The interface for external memory may be used to connect to an external memory card, for example, a micro SD card, to extend a storage capability of the electronic device 10. The external memory card communicates with the processor 110 via the interface for external memory, to implement a data storage function. The universal serial bus interface is configured for communication between the electronic device 10 and another electronic device. The subscriber identification module card interface is configured to communicate with a SIM card installed in the electronic device 10, for example, read a phone number stored in the SIM card, or write a phone number into the SIM card.

In some embodiments, the electronic device 10 further includes the button 101, a motor, an indicator, and the like. The button 101 may include a volume button, a power-on/power-off button, and the like. The motor is configured to enable the electronic device 10 to generate vibration effect, for example, generate vibration when the electronic device 10 of a user is called, to prompt the user to answer a call from the electronic device 10. The indicator may include a laser indicator, a radio frequency indicator, an LED indicator, and the like.

This application provides an electronic device, including a memory, configured to store instructions to be executed by one or more processors of the electronic device, and a processor that is one of the processors of the electronic device, configured to perform the driving method mentioned in this application.

It should be noted that all units/modules mentioned in device embodiments of this application are logical units/modules. Physically, one logical unit/module may be one physical unit/module, may be a part of one physical unit/module, or may be implemented by using a combination of a plurality of physical units/modules. Physical implementations of these logical units/modules are not the most important, and a combination of functions implemented by these logical units/modules is a key to resolve the technical problem provided in this application. In addition, to highlight an innovative part of this application, a unit/module that is not closely related to resolving the technical problem provided in this application is not introduced in the foregoing device embodiments of this application. This does not mean that there are no other units/modules in the foregoing device embodiments.

It should be noted that: In the examples and specification of this patent, relational terms such as first and second are merely used to distinguish one entity or operation from another, and do not necessarily require or imply any such actual relationship or order between these entities or operations. Moreover, the terms "include" or any other variant thereof is intended to cover a non-exclusive inclusion, so that a process, a method, an article, or a device that includes a list of elements not only includes those elements but also includes other elements that are not expressly listed, or further includes elements inherent to such a process, method, article, or device. An element preceded by "includes a ..." does not, without more constraints, preclude the existence of additional identical elements in the process, method, article, or device that includes the element.

Although this application has been illustrated and described with reference to some preferred embodiments of this application, a person of ordinary skill in the art should understand that various changes may be made to this application in form and detail without departing from the spirit and scope of this application.

## Claims

1. A drive circuit, comprising a power amplifier module, a boost module, and a first audio device, wherein the boost module comprises a first boost unit and a second boost unit;
the power amplifier module is configured to output a first audio signal to the first boost unit, and output a second audio signal to the second boost unit, wherein a phase of the first audio signal is opposite to a phase of the second audio signal; and
the first boost unit is configured to perform voltage amplification on the first audio signal to obtain a third audio signal, and send the third audio signal to a positive electrode of the first audio device, and the second boost unit is configured to perform voltage amplification on the second audio signal to obtain a fourth audio signal, and send the fourth audio signal to a negative electrode of the first audio device.

2. The drive circuit according to claim 1, wherein the first audio device is a piezoelectric ceramic component.

3. The drive circuit according to claim 2, wherein the power amplifier module comprises a first power amplifier, a first filter, and a second filter, and the power amplifier is separately connected to the first filter and the second filter;
the first power amplifier is configured to output a fifth audio signal to the first filter, and output a sixth audio signal to the second filter, wherein a phase of the fifth audio signal is opposite to a phase of the sixth audio signal;
the first filter is configured to perform filtering on the fifth audio signal to obtain the first audio signal; and
the second filter is configured to perform filtering on the sixth audio signal to obtain the second audio signal.

4. The drive circuit according to claim 3, wherein the first boost unit comprises a first operational amplifier, and the second boost unit comprises a second operational amplifier;
a first end of the first operational amplifier is connected to the first filter, and a second end of the first operational amplifier is connected to a positive electrode of the piezoelectric ceramic component; and
a first end of the second operational amplifier is connected to the second filter, and a second end of the second operational amplifier is connected to a negative electrode of the piezoelectric ceramic component.

5. The drive circuit according to claim 4, wherein the first boost unit further comprises a first matching unit, and the second boost unit further comprises a second matching unit;
that the second end of the first operational amplifier is connected to the positive electrode of the piezoelectric ceramic component comprises: the second end of the first operational amplifier is connected to a first end of the first matching unit, and a second end of the first matching unit is connected to the positive electrode of the piezoelectric ceramic component; and
that the second end of the second operational amplifier is connected to the negative electrode of the piezoelectric ceramic component comprises: the second end of the second operational amplifier is connected to a first end of the second matching unit, and a second end of the second matching unit is connected to the negative electrode of the piezoelectric ceramic component.

6. The drive circuit according to claim 5, wherein the boost module further comprises a voltage amplification unit, a first end of the voltage amplification unit is connected to the first operational amplifier, and a second end of the voltage amplification unit is connected to the second operational amplifier;
the voltage amplification unit is configured to amplify a first voltage of a power supply to obtain a second voltage;
the first operational amplifier is configured to send the third audio signal to the positive electrode of the piezoelectric ceramic component by using the second voltage; and
the second operational amplifier is configured to send the fourth audio signal to the negative electrode of the piezoelectric ceramic component by using the second voltage.

7. The drive circuit according to any one of claims 3 to 6, further comprising a switch module and a second audio device, wherein
the switch module is configured to control electrical connection and disconnection between the first power amplifier and the second audio device, and control electrical connection and disconnection between the first power amplifier and the piezoelectric ceramic component.

8. The drive circuit according to claim 7, wherein the switch module comprises a first switch unit and a second switch unit, wherein
a first end of the first switch unit is connected to the first power amplifier, a second end of the first switch unit is connected to the first filter, and a third end of the first switch unit is connected to a positive electrode of the second audio device; and
a first end of the second switch unit is connected to the first power amplifier, a second end of the second switch unit is connected to the second filter, and the second end of the second switch unit is connected to a negative electrode of the second audio device.

9. The drive circuit according to any one of claims 3 to 6, further comprising a second audio device, wherein the power amplifier module further comprises a second power amplifier, and the second power amplifier is connected to the second audio device; and
the second power amplifier is configured to output a seventh audio signal to the second audio device.

10. The drive circuit according to claim 1 or 2, further comprising a second audio device, wherein the power amplifier module comprises a multichannel power amplifier;
a first channel of the multichannel power amplifier is connected to the first audio device; and
a second channel of the multichannel power amplifier is connected to the second audio device.

11. The drive circuit according to any one of claims 8 to 10, wherein the second audio device is a speaker component.

12. The drive circuit according to any one of claims 1 to 6, further comprising a controller and a digital signal processor, wherein
the digital signal processor is configured to output an eighth audio signal to the digital signal processor; and
the digital signal processor is configured to perform digital processing on the eighth audio signal to obtain a ninth audio signal, and output the ninth audio signal to the power amplifier module.

13. A driving method, applied to an electronic device, wherein the electronic device comprises the drive circuit according to any one of claims 1 to 12, and the method comprises:
determining that the first audio device needs to be driven to play target audio;
controlling the power amplifier module to output a first audio signal corresponding to the target audio to the first boost unit and output a second audio signal corresponding to the target audio to the second boost unit, wherein a phase of the first audio signal is opposite to a phase of the second audio signal; and
controlling the first boost unit to perform voltage amplification on the first audio signal to obtain a third audio signal, and send the third audio signal to the positive electrode of the first audio device, and controlling the second boost unit to perform voltage amplification on the second audio signal to obtain a fourth audio signal, and send the fourth audio signal to the negative electrode of the first audio device.

14. The driving method according to claim 13, wherein determining that the first audio device needs to be driven to play the target audio comprises:
detecting an incoming call;
obtaining an ambient noise value of the electronic device; and
in response to the ambient noise value being greater than a first threshold and a noise duration being greater than a first duration, determining that the first audio device and the second audio device need to be driven to play incoming call audio.

15. The driving method according to claim 14, wherein the method further comprises:
in response to the ambient noise value being less than or equal to the first threshold, determining that the second audio device needs to be driven to play the incoming call audio; and
in response to the ambient noise value being greater than the first threshold and the noise duration being less than or equal to the first duration, determining that the second audio device needs to be driven to play the incoming call audio.

16. An electronic device, comprising the drive circuit according to any one of claims 1 to 12.

17. An electronic device, comprising: a memory, configured to store instructions to be executed by one or more processors of the electronic device; and
a processor that is one of the processors of the electronic device, configured to perform the driving method according to any one of claims 13 to 15.
